# EUROPEAN PATENT APPLICATION

(11) **EP 4 567 801 A1**
(43) Date of publication of application: **11.06.2025**
(21) Application number: 23215122.5
(22) Date of filing: 08.12.2023
(51) Int. Cl.: G11C 7/10, G11C 11/16, G11C 8/04, G11C 19/08, G06F 5/10

(54) **RUNTIME-RECONFIGURABLE MEMORY**

(71) Applicant: IMEC VZW, 3001 Leuven (BE)
(72) Inventor: Couet, Sebastien, 1390 Grez-Doiceau (BE); Perumkunnil, Manu Komalan, 3000 Leuven (BE)
(74) Representative: Roth, Sebastian

(57) **Abstract**

The present disclosure relates to a memory device, and to a controller for controlling the write and read of data into a memory of the memory device. The memory comprises a plurality of memory structures, and each memory structure comprises an array of memory cells configured to sequentially store data. The controller is configured to receive an instruction to write data into a particular memory structure of the memory, or to read data from the particular memory structure, wherein the instruction indicates the number of bits of the data to be written or read. The controller is further configured to control the memory to write or read the data into or from the particular memory structure, wherein one bit of the data is pushed into or pulled out of the particular memory structure in each of one or more clock cycles.

## Description

### TECHNICAL FIELD

The present disclosure relates to a memory device, and to a controller for controlling a write and read of data into a memory of the memory device. The memory comprises a plurality of memory structures, and each memory structure comprises an array of memory cells configured to sequentially store data.

### BACKGROUND

In the field of computing devices, a very large variety of memory architectures have been developed over the last decades depending on various technical constraints, for instance, depending on speed requirements, memory requirements, density requirements, and application type. For example, the static random-access memory (SRAM) architecture has been exploited for its high operating speed, but with the drawback related to its areal density. By contrast, the dynamic random-access memory (DRAM) architecture allows for a denser storage, but comes at the expense of speed. More recent advances introduced the spin-transfer torque magnetic random-access memory (STT-MRAM) architecture, a non-volatile resistive memory exploiting a magnetic tunnel junction (MTJ) with high operation speed, and robust endurance.

Typically, a specific memory architecture is chosen for each application, with the aim of maximizing a set of key features. Consequently, a computing device usually comprises several types of memory architectures. For example, for some applications a memory architecture having a low latency and a low storage capacity is preferred, whereas for other applications, elsewhere in the system, another memory architecture is preferred because of its high latency and large storage capacity. However, this is not a versatile system and can be improved.

### SUMMARY

In view of the above, an objective of the present disclosure is to provide a memory device that can work with an arbitrary amount of data. An objective is also to make the latency and/or capacity adaptable over a certain range while using the same memory architecture.

These and other objectives are achieved by the embodiments of the invention provided in the independent claims. Advantageous implementations of these embodiments are described in the dependent claims.

A first aspect of this disclosure provides a controller for a memory, wherein the memory comprises a plurality of memory structures, wherein each memory structure comprises an array of memory cells and is configured to sequentially store one bit of data in each memory cell, and wherein the controller is configured to: receive an instruction to write data into a particular memory structure of the memory or to read data from the particular memory structure, wherein the instruction indicates the number of bits of the data to be written or read; and control the memory to write or read the data into or from the particular memory structure, wherein one bit of the data is pushed into or pulled out of the particular memory structure in each of one or more clock cycles.

The array of memory cells in each of the plurality of memory structures may be a linear array of memory cells, or may be an array of consecutively stacked memory cells. The memory may, for example, be a 3D magnetic memory comprising stacked magnetic memory cells, which may be defined by magnetic pinning sites. The plurality of memory structures may form an array of the memory, so that the array of each memory structure may be considered a sub-array of the entire memory array.

The instruction received by the controller may be a variable-width instruction, which supports different data sizes. Thus, it provides more flexibility and may allow optimizing the performance of the memory for various types of applications. The instruction may use any kind of syntax to indicate the number of bits.

The controller of the first aspect and the related memory allow working with an arbitrary amount of data to be stored in the memory. An adaptable range of the latency and/or capacity is provided while using the same memory.

In an implementation of the controller, the instruction further comprises configuration information, wherein the configuration information indicates a burst length with which the data is to be written or read.

In an implementation of the controller, the burst length is a bit, or a byte, or a word, or a block, wherein a block is sized to include all memory cells of the linear array of the particular memory structure.

In an implementation of the controller, the configuration information comprises two bits which indicate the burst length.

Thus, the overhead of sending the instruction to the controller is minimal.

In an implementation of the controller, the controller is configured to address the memory in accordance with the burst length, when controlling the memory to write or read the data.

In an implementation of the controller, the controller is configured to control the memory to write or read the data in the form of a data burst having the burst length.

Based on the controller's addressing and/or controlling of the memory, the memory may be configured to write the data into the memory structure, or read the data from the memory structure, using the burst length.

In an implementation of the controller, the instruction further comprises address information indicating the particular memory structure, and the controller is configured to control the memory based on the address information.

In an implementation of the controller, the controller comprises an address decoder configured to decode the address information and to control the memory in accordance with the decoded address information.

In an implementation of the controller, the controller comprises a clock configured to generate the one or more clock cycles.

A second aspect of this disclosure provides a memory device comprising the controller and the memory according to the first aspect or any implementation thereof.

The memory device of the second aspect achieves the same advantages as described above for the controller of the first aspect.

In an implementation of the memory device, each memory structure of the memory comprises a magnetic channel that forms a string of magnetic domains, wherein each magnetic domain forms a magnetic memory cell that is configured to store one magnetic bit.

The magnetic channel may be formed through a stack comprising a plurality of dielectric layers (e.g., silicon oxide) and silicon-based layers (e.g., silicon nitride), which are alternatingly arranged one on the other. A plurality of pinning sites, which are defined by the plurality of layers of the stack, may be formed in the magnetic channel. Each pinning site may be configured to store one magnetic bit. The magnetic channel may thus store a plurality of magnetic bits along its length. The pinning sites may be generated by the alternatingly layers and their interfaces. The pinning sites are locations where magnetic domains (or more specifically, the domain walls that separate these domains) are "pinned" or stabilized. Thus, each pinning site is configured to stabilize (and thus configured to store) a particular magnetic state in the magnetic channel, the magnetic state representing a (magnetic) bit of information.

The magnetic channel may accordingly store a bit sequence. The magnetic memory device may comprise multiple such magnetic channels, one for each memory structure. The multiple magnetic channels may thereby be arranged in parallel to each other and/or may be arranged in an array of magnetic channels, for instance, an array comprising a plurality of rows and columns. That is, the magnetic channels maybe arranged in a 2D array and may extend along the third dimension. Thus, the memory device can exploit all three dimensions and depart from the usual planar configuration. Consequently, the memory device of the second aspect may have a significantly increased memory density, and can store more information that a conventional, planar magnetic memory device.

The magnetic channel of the memory device of the second aspect may be a "macaroni" type channel, which comprises a hollow magnetic cylinder of magnetic material and a dielectric filling. Alternatively, the magnetic channel may be a full magnetic channel made of a magnetic material and, for example, having a varying diameter that changes along its extension direction.

In an implementation of the memory device, each memory structure of the memory comprises a SOT track, coupled to the magnetic channel, and the memory is configured to write a magnetic bit into the magnetic channel by passing a current through the SOT track, in order to push the magnetic bit into the memory cell closest to the SOT track.

In an implementation of the memory device, each memory structure of the memory comprises a MTJ coupled to the magnetic channel, and the memory is configured to read a magnetic bit from the magnetic channel by passing a current through the MTJ and determining a tunnel-magnetoresistance, wherein the magnetic bit stored in the memory cell closest to the MTJ is read.

The memory structure may comprise a first metallic layer, which is arranged between the MTJ and the stack, through which the magnetic channel is formed. The first metallic layer is thus arranged on a first end of the magnetic channel and on the last layer of the stack. This first metallic layer may be configured as the SOT track. Alternatively, a second metallic layer may be configured as the SOT track. If the memory structure comprises the second metallic layer, the stack is provided on the second metallic layer. In this case, a second end of the magnetic channel and the first layer of the stack are arranged on the second metallic layer. The memory structure may comprise the first metallic layer and/or the second metallic layer. In an implementation of the memory device, each memory structure of the memory comprises an electrode, and the memory is configured to push magnetic bits along the magnetic channel from one memory cell to the next memory cell by passing a current through the electrode.

The electrode may be arranged on the first metallic layer. The electrode may also be arranged on the second metallic layer or the second end of the magnetic channel. The memory structure may also comprise a first electrode arranged on the first metallic layer, and a second electrode arranged on the second end of the magnetic channel (if there is no second metallic layer) or on the second metallic layer.

Accordingly, the memory device of the second aspect can employ SOT for writing information into the magnetic channel, and can employ TMR using the MTJ to read out information from the magnetic channel. Moreover, information can be moved in the magnetic channel by a push current, and thus moving magnetic bits stored in the magnetic channel from one pinning site to the next employing the electrode(s).

In summary of the above, the memory architecture of this disclosure may be based on sequential read/write memory structures, for example, using magnetic bits vertically stacked in the form of oriented magnetic domains inside a magnetic channel made of a magnetic material (e.g., cobalt, nickel, iron, alloys thereof,...). Domain pinning may be achieved by using the stack (e.g., silicon nitride/silicon oxide stack), which may have a morphology depending on the application of interest. On the one hand, writing can be performed at the bottom of the stack by injecting a current through a SOT generating track, which enables the bottom-most magnetic bit or top-most magnetic bit (depending on whether the first metallic layer or the second metallic layer is used as SOT track) to have an orientation depending on the current's polarity. On the other hand, reading is performed through the MTJ used to sense the magnetic stray field of the domain closest to the MTJ by reading the resistance of the MTJ and through the TMR effect. After a writing operation, the bits are pushed along the magnetic channel by applying a current from the bottom of stack to the top through the magnetic channel, or vice versa (using the first and/or second electrode).

A third aspect of this disclosure provides a method for controlling a memory, wherein the memory comprises a plurality of memory structures, wherein each memory structure comprises an array of memory cells and is configured to sequentially store one bit of data in each memory cell, and wherein the method comprises: receiving an instruction to write data into a particular memory structure of the memory or to read data from the particular memory structure, wherein the instruction indicates the number of bits of the data to be written or read; and controlling the memory to write or read the data into or from the particular memory structure, wherein one bit of the data is pushed into or pulled out of the particular memory structure in each of one or more clock cycles.

The method of the third aspect achieves the same advantages as the controlled of the first aspect and may be extended by respective implementations as described above for the controller of the first aspect.

### BRIEF DESCRIPTION OF THE DRAWINGS

The above described aspects and implementations are explained in the following description of embodiments with respect to the enclosed drawings:
- FIG. 1: shows a controller and a memory device according to this disclosure.
- FIG. 2: shows different data sizes stored into a memory structure of an exemplary memory.
- FIG. 3: shows schematics representing an exemplary memory device according to this disclosure.
- FIG. 4: illustrates an operation to write data into a memory structure of the memory device of FIG. 3.
- FIG. 5: illustrates an operation to read data from a memory structure of the memory device of FIG. 3.
- FIG. 6: shows a method for controlling a memory according to this disclosure.

### DETAILED DESCRIPTION OF EMBODIMENTS

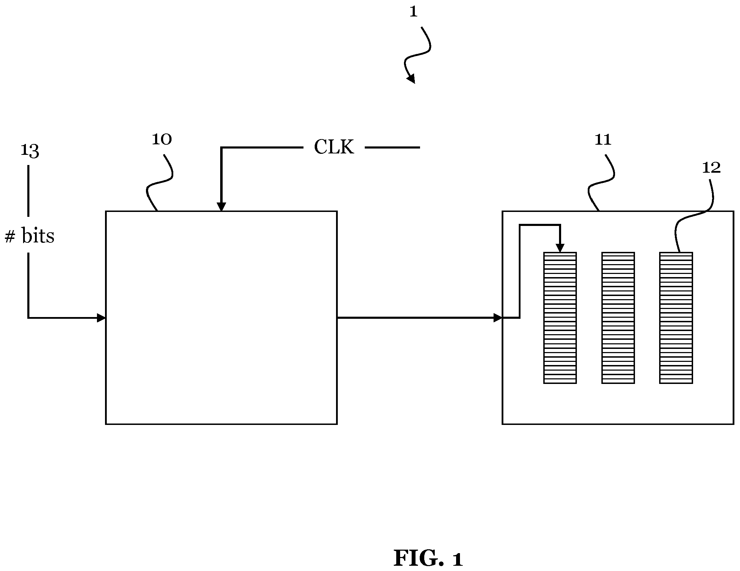

FIG. 1 shows a controller 10 according to this disclosure, a memory 11, and a memory device 1 of this disclosure, which comprises the controller 10 and the memory 11.

The memory 11 comprises a plurality of memory structures 12, wherein each memory structure 12 comprises an array of memory cells and is configured to sequentially store one bit of data in each memory cell. For instance, the memory 11 may be a 3D magnetic memory comprising a plurality of magnetic memory structures 12 having each a magnetic channel, as described above.

The controller 10 may comprise a processor or processing circuitry (not shown) configured to perform various operations described in this disclosure. The processing circuitry may comprise hardware and/or the processing circuitry may be controlled by software. The hardware may comprise analog circuitry or digital circuitry, or both analog and digital circuitry. The digital circuitry may comprise components such as application-specific integrated circuits (ASICs), field-programmable arrays (FPGAs), digital signal processors (DSPs), or multi-purpose processors. The controller 10 may further comprise memory circuitry, which stores one or more instruction(s) that can be executed by the processor or by the processing circuitry, in particular under control of the software. For instance, the memory circuitry may comprise a non-transitory storage medium storing executable software code which, when executed by the processor or the processing circuitry, causes the operations of the controller 10 to be performed. In particular, the controller 10 is configured to perform the following operations.

The controller 10 is configured to receive an instruction 13 to write data into a particular memory structure 12 of the memory 11, or to read data from the particular memory structure 12. Receiving the instruction 13 may comprise processing or parsing a received message, which may contain one or more instructions, for instance, in a header of the message. Each instruction may indicate certain information, and may be included in the message and comprise one or more indication bits. In this case, the instruction 13 indicates the number of bits of the data to be written or read.

The controller 10 is further configured to control the memory 11 to write or read the data into or from the particular memory structure 12, wherein one bit of the data is pushed into or pulled out of the particular memory structure 12 in each of one or more clock cycles. Controlling the memory 11 may comprise addressing the memory 11, i.e., using an address of the memory 11 and/or an address of the particular memory structure 12 that is to be used for writing or reading. The address information maybe included in the instruction 13. Controlling the memory 11 may further comprise sending a predetermined command to the memory 11, so that the memory 11 can perform the requested write or read operation based on the command. The command may, for example, indicate whether a write or read is to be performed by the memory 11, and the number of bits to be written or read. For instance, the controller may command the memory 11 to write or read the data in the form of a data burst having a certain burst length. The burst length may be derived from the instruction 13, for example, from configuration information in the instruction 13, wherein the configuration information indicates the burst length. The configuration information may comprise two or more bits to indicate the burst length.

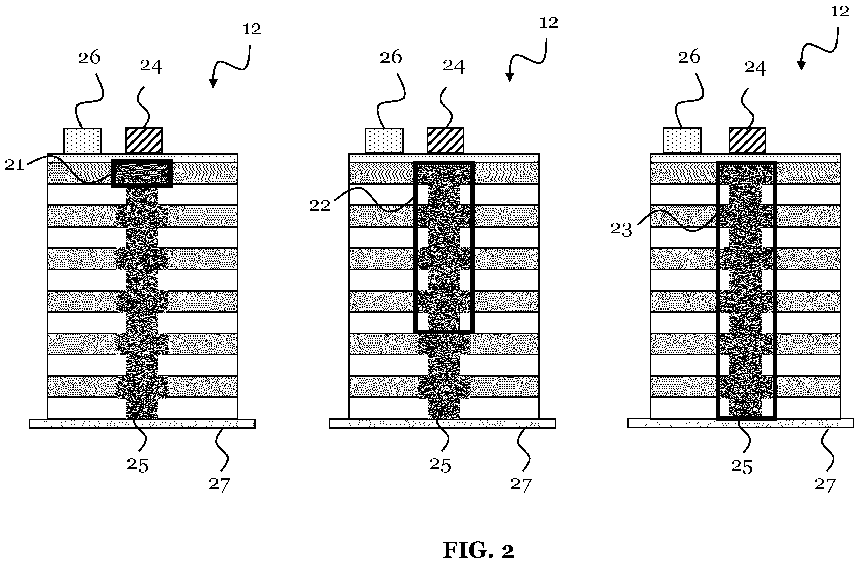

FIG. 2 shows different data sizes that can be stored in a memory structure 12 of an exemplary memory 11, which can be used in a memory device 1 of this disclosure. The memory structure 12 is in this case of a magnetic memory, as described above.

That is, the memory structure 12 comprises a magnetic channel 25 that forms a string of magnetic domains. Each magnetic domain forms a magnetic memory cell that is configured to store one magnetic bit. The magnetic channel 25 may be formed through a stack of alternating layers, for instance, silicon nitride and silicon oxide layers. For writing data, the memory structure 12 comprises a SOT track 27 coupled to the magnetic channel 25. The memory 11 is configured to write a magnetic bit into the magnetic channel 25 by passing a current through the SOT track 26. The passing of the SOT current pushes a magnetic bit into the memory cell that is closest to the SOT track 27. For reading data, the memory structure 12 comprises a MTJ 24 coupled to the magnetic channel 25. The memory 11 is configured to read a magnetic bit from the magnetic channel 25 by passing a current through the MTJ 24, and thereby determining a tunnel-magnetoresistance. In this way, the magnetic bit stored in the memory cell that is closest to the MTJ 24 can be read. For moving data, the memory structure 12 comprises an electrode 26. The memory 11 is configured to push magnetic bits along the magnetic channel 25 from one memory cell to the next memory cell, by passing a push current through the electrode 26.

The above-described actions of the memory 11 can be controlled by the controller 10. That is, the controller 10 can control the memory 11 to perform the write, or read, or push. For the read or write, the size of the data that is written or read can be adapted by the controller 10. For instance, the controller 10 can control the memory 11 to read or write only one bit 21 of data, as illustrated in FIG. 2(a). This enables full random access with an access time as low as 1-2 ns. Alternatively, the controller 10 can control the memory 11 to read or write a byte 22 of data in one operation, as illustrated in FIG. 2(b). This may allow emulating random access with an access time in the order of 2-300 ns. Alternatively, a word, or a full block 23 as illustrated in FIG. 2(c), may be written or read by the memory 11 upon instruction from the controller 10 in one operation. As shown, a block 23 includes all memory cells of the array of the particular memory structure 12. In all cases, one bit of data is written or read per clock cycle. That is, an operation can be one or more clock cycles.

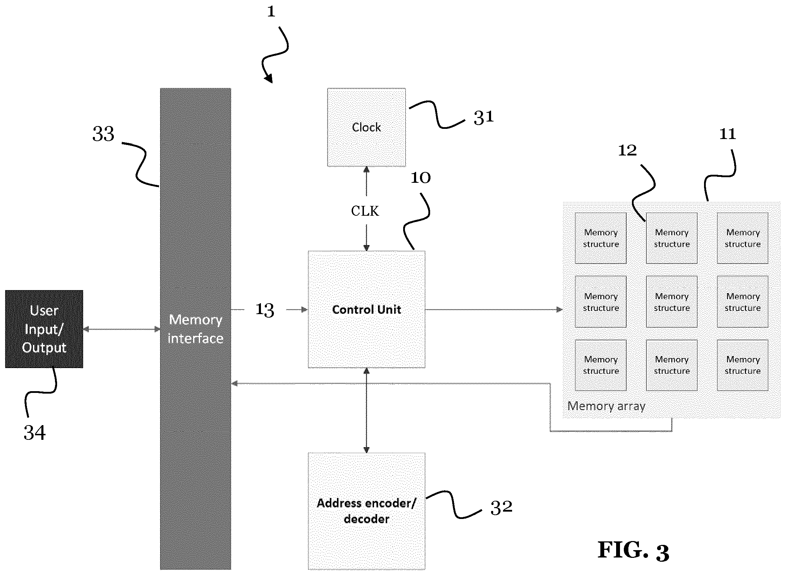

FIG. 3 shows schematics representing an exemplary memory device 1 according to this disclosure. The memory device 1 includes the controller 10 ("control unit") and the memory 11 with its memory structures 12. Also in this example, the memory structures 12 may each have a magnetic material channel forming a vertical pillar of stacked magnetic domains, each configured to form a magnetic bit. The memory device 1 may further include a clock 31 (which may also be part of the controller 10) to generate the one or more clock cycles, may include an address encoder/decoder 32, and may include a memory interface 33 configured to handle user input/output 34.

The control unit 10 receives one or more instructions 13 to read or write a chunk of data form/into one or of the memory structures 12. The instruction 13 indicates a bit size of the data (chunk) to be written or read. Since data is stored sequentially into the memory structures 12, for instance vertically in a pillar of memory cells, the same memory structure 12 may be configured and used, regardless of the size of the chunk of data to handle (as long as it does not exceed the maximum size of the memory structure 12), and regardless of the time allocated to fetch it from the memory structure 12, without needing changes regarding the data pathways that connects to the memory structures 12.

The instruction 13 may comprises address information, which indicates the memory structure 12 to write in or to read from. More than one memory structure 12 can be indicated. The controller 10 is configured to control the memory 11 based on the address information. In particular, the address encoder/decoder 32 can decode the address information, and the controller 10 can control the memory 11 in accordance with the decoded address information.

Accessing, writing to, and reading from the memory structure 12 may be akin to what is currently done for conventional memory systems, where different blocks communicate with one another through busses, lines, and similar signal tracks. It may also include an interface handling the memory program/read/erase requests and the like. The following shows how it handles chunk of data with different size.

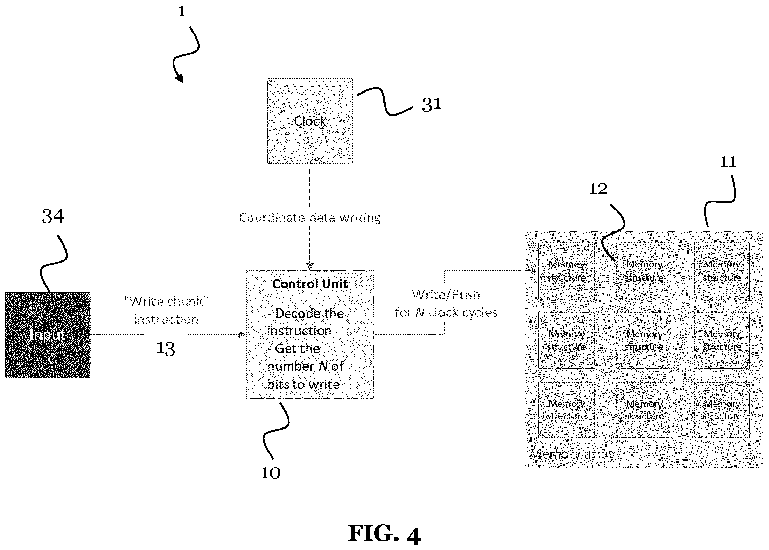

FIG. 4 illustrates an operation to write data into a memory structure 12 of the memory 11 of the memory device 1 of FIG. 3, wherein the memory 11 is controlled by the controller 10. In order to write information into the array of a given memory structure 12, the controller 10 receives the instruction 13 (e.g., from a central processing unit) regarding what data to write, where to write it (e.g., from a memory controller), how many bits to write (e.g., denoted here by the parameter N) and how to write it (e.g., the configuration of the data, like a burst). Then, in coordination with the clock 31, the controller 10 controls the memory 11 to successively write a first bit in the first memory cell of the memory structure 12 (e.g., the lowest magnetic domain of a magnetic memory structure), and to push it along the array of the memory structure 12. Then, the controller 10 and the memory 11 repeat this with the next bit for a total of N clock cycles. After that *N*^{th} write-push iteration, the writing operation is stopped as it is completed. A representation of the process flow is shown in FIG. 4.

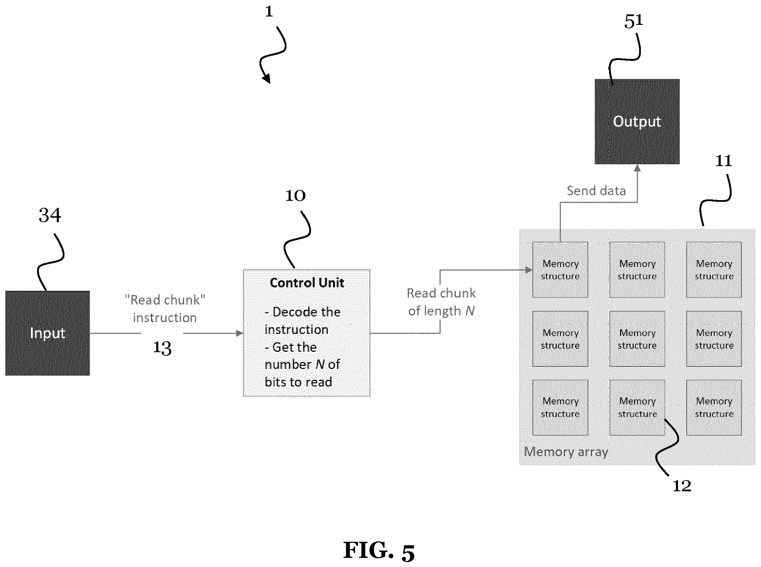

FIG. 5 illustrates an operation to read data from a memory structure 12 of the memory 11 of the memory device 1 of FIG. 3, wherein the memory 11 is controlled by the controller 10. In order to read a given chunk of information (data) that is in the array of a given memory structure 12, the controller 10 receives an instruction 13 regarding where to read (e.g., from a memory controller), how many bits to read (also denoted by the parameter N), and how to read it (e.g., the configuration of the data, like a burst). Then, the controller 10 reads the whole chunk of data of size N and may send it to one or multiple registers for further operations. The process flow of that operation is represented in FIG. 5.

As noted above, each memory structure 12 can be partitioned and addressed in at least three different ways, as is illustrated in FIG. 2. That is, either by bit, by byte, bay word, or by block.

In the case of a bit addressable memory 11, each bit is written one by one, and read one by one. In that case, the minimal amount of data is accessed at once, but the access time is the shortest. However, it is also the configuration with the lowest bandwidth efficiency (i.e., the lowest information rate that can be transmitted over a given bandwidth) to handle large chunks of data such as data structures.

In the case of a byte addressable memory 11, the write operation is performed for groups of 8 bits and completed after 8 clock cycles. For example, the data is accessed and read by chunk of 8 magnetic domains, and that naturally takes more time. The bandwidth efficiency to handle large chunks of data such as data structures is however larger that if it was accessed bit by bit.

For a word addressable memory 11, depending on the size of the chunk of memory cells to write or read, the amount of data accessible at once is increased, the access time is decreased, and the bandwidth efficiency is improved accordingly.

In the case of a block addressable memory, the whole array of the memory structure 12 is overwritten and that takes as many clock cycles as there are memory cells. For the reading operation, the entire memory structure 12 is accessed and read. Therefore, it has the largest bandwidth efficiency to handle large chunks of data such as data structures.

The memory 11 can be selectively used as bit addressable memory 11, as byte addressable memory 11, as word addressable memory 11, or as block addressable memory, depending on the controller 10 and/or the instruction 13. That is, the controller 10 can select how to use the memory 11. The controller 10 may also select different ways of addressing /controlling for different memory structures 12 of the memory 11.

The burst length, i.e. the configuration information to know with which configuration the data should be written or read, may be located in the instruction 13 sent to the controller 10. This instruction 13 may take, for example, the form of a 2-bits command, such as the one in Table 1.

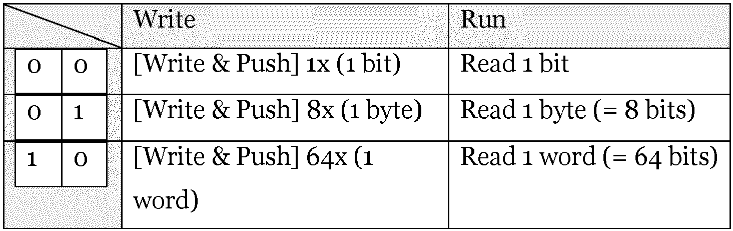

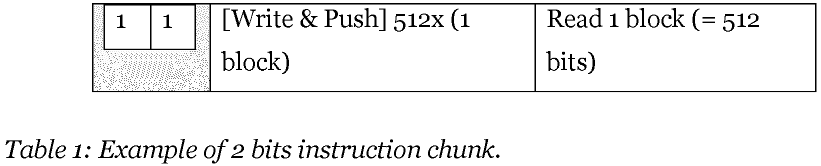

In this table, 00 is used for bit-wise partitioning, 01 for byte-wise partitioning, 10 for word-wise partitioning and 11 for block-wise partitioning (i.e., addressing and controlling the memory 11 to write or read bit-wise, byte-wise, word-wise, or block-wise as explained above). The definition of byte, word, or block - in terms of number of bits - may be variable depending on the application(s), and is therefore not limited to what is shown in Table 1. What is more, if more configurations were required (e.g., 6 configurations such as {1 bit, 4 bits, 16 bits, 64 bits, 256 bits, 512 bits}), the command would then be made up of more than 2 bits.

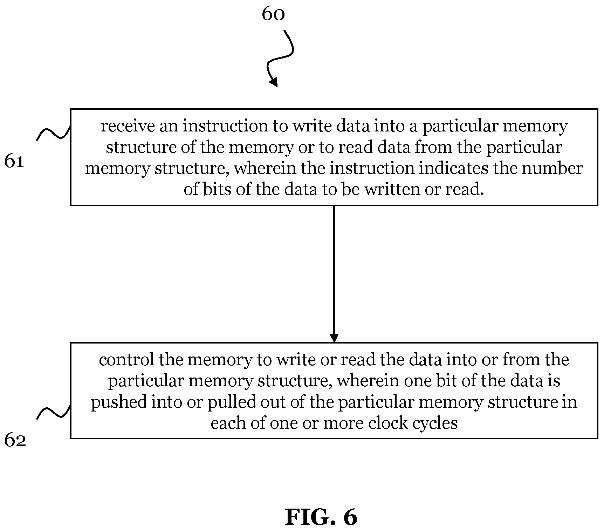

FIG. 6 shows a method 60 for controlling a memory 11 according to this disclosure. The memory 11 comprises a plurality of memory structures 12, wherein each memory structure 12 comprises an array of memory cells and is configured to sequentially store one bit of data in each memory cell. The method 60 comprises a step 61 of receiving an instruction 13 to write data into a particular memory structure 12 of the memory 11, or to read data from the particular memory structure 12. The instruction 13 indicates the number of bits of the data to be written or read. The method 60 further comprises a step 62 of controlling the memory 11 to write or read the data into or from the particular memory structure 12, wherein one bit of the data is pushed into or pulled out of the particular memory structure 12 in each of one or more clock cycles.

In summary, the solution of this disclosure provides a way to work with an arbitrary amount of data with an adaptable range of latency and/or capacity, thereby using one and the same memory 11. This is enabled by the sequential storing of data into the memory structures 12 and an on-chip array configuration partitioning system. The solutions are usable for different applications. For example, a bit-addressable memory can be used to store single-bit values (Boolean...) and make operations with basic arithmetic. A byte- or word-addressable memory can be used to store larger multiple-bits values (int8, int16, int32, single-precision, double-precision) and make operations with at least the lowest bit precision. This could be used for computer graphics, 2D image processing, 3D image processing. A block addressable memory may be used to store and make operations on whole blocks or pages of data, for example, for streaming applications, irregular vector operations, or matrix operations.

In the claims as well as in the description of this disclosure, the word 'comprising' does not exclude other elements or steps and the indefinite article 'a' or 'an' does not exclude a plurality. A single element may fulfill the functions of several entities or items recited in the claims. The mere fact that certain measures are recited in the mutual different dependent claims does not indicate that a combination of these measures cannot be used in an advantageous implementation.

## Claims

1. A controller (10) for a memory (11),
wherein the memory (11) comprises a plurality of memory structures (12), wherein each memory structure (12) comprises an array of memory cells and is configured to sequentially store one bit of data in each memory cell, and wherein the controller (10) is configured to:
receive an instruction (13) to write data into a particular memory structure (12) of the memory (11) or to read data from the particular memory structure (12), wherein the instruction (13) indicates the number of bits of the data to be written or read; and
control the memory (11) to write or read the data into or from the particular memory structure (12), wherein one bit of the data is pushed into or pulled out of the particular memory structure (12) in each of one or more clock cycles.

2. The controller (10) of claim 1, wherein the instruction (13) further comprises configuration information, wherein the configuration information indicates a burst length with which the data is to be written or read.

3. The controller (10) of claim 2, wherein the burst length is a bit (21), or a byte (22), or a word, or a block (23), wherein a block (23) is sized to include all memory cells of the array of the particular memory structure (12).

4. The controller (10) of claim 2 or 3, wherein the configuration information comprises two bits which indicate the burst length.

5. The controller (10) of one of the claims 2 to 4, wherein the controller (10) is configured to address the memory (11) in accordance with the burst length, when controlling the memory (11) to write or read the data.

6. The controller (10) of one of the claims 2 to 5, wherein the controller (10) is configured to control the memory (11) to write or read the data in the form of a data burst having the burst length.

7. The controller (10) of one of the claims 1 to 6, wherein the instruction (13) further comprises address information indicating the particular memory structure (12), and the controller (10) is configured to control the memory (11) based on the address information.

8. The controller (10) of claim 7, wherein the controller (10) comprises an address decoder (32) configured to decode the address information and to control the memory (11) in accordance with the decoded address information.

9. The controller (10) of one of the claims 1 to 8, wherein the controller (10) comprises a clock (31) configured to generate the one or more clock cycles.

10. A memory device (1) comprising the controller (10) and the memory (11) according to one of the claims 1 to 9.

11. The memory device (1) of claim 10, wherein each memory structure (12) of the memory (11) comprises a magnetic channel (25) that forms a string of magnetic domains, wherein each magnetic domain forms a magnetic memory cell that is configured to store one magnetic bit.

12. The memory device (1) of claim 11, wherein each memory structure (12) of the memory (11) comprises a spin-orbit-torque, SOT, track, (27) coupled to the magnetic channel (25), and the memory (11) is configured to write a magnetic bit into the magnetic channel (25) by passing a current through the SOT track (27), in order to push the magnetic bit into the memory cell closest to the SOT track (27).

13. The memory device (1) of claim 11 or 12, wherein each memory structure (12) of the memory (11) comprises a magnetic tunnel junction, MTJ, (24) coupled to the magnetic channel (25), and the memory (11) is configured to read a magnetic bit from the magnetic channel (25) by passing a current through the MTJ (24) and determining a tunnel-magnetoresistance, wherein the magnetic bit stored in the memory cell closest to the MTJ (24) is read.

14. The memory device (1) of one of the claims 11 to 13, wherein each memory structure (12) of the memory (11) comprises an electrode (26), and the memory (11) is configured to push magnetic bits along the magnetic channel (25) from one memory cell to the next memory cell by passing a current through the electrode (26).

15. A method (60) for controlling a memory (11),
wherein the memory (11) comprises a plurality of memory structures (12), wherein each memory structure (12) comprises an array of memory cells and is configured to sequentially store one bit of data in each memory cell, and wherein the method (60) comprises:
receiving (61) an instruction (13) to write data into a particular memory structure (12) of the memory (11) or to read data from the particular memory structure (12), wherein the instruction (13) indicates the number of bits of the data to be written or read; and
controlling (62) the memory (11) to write or read the data into or from the particular memory structure (12), wherein one bit of the data is pushed into or pulled out of the particular memory structure (12) in each of one or more clock cycles.
